Europäisches Patentamt

European Patent Office

Office européen des brevets

(11) Veröffentlichungsnummer: **0 416 476 A2**

# (12) EUROPÄISCHE PATENTANMELDUNG

(21) Anmeldenummer: **90116729.6**

(22) Anmeldetag: **31.08.90**

(51) Int. Cl.5: **H03H 7/46**

(30) Priorität: **07.09.89 DE 3929702**

(43) Veröffentlichungstag der Anmeldung:
**13.03.91 Patentblatt 91/11**

(84) Benannte Vertragsstaaten:
**AT BE CH DE ES FR GB IT LI NL**

(71) Anmelder: **Standard Elektrik Lorenz
Aktiengesellschaft
Lorenzstrasse 10
W-7000 Stuttgart 40(DE)**

(84) **CH DE ES FR GB IT LI NL AT**

Anmelder: **ALCATEL N.V.
Strawinskylaan 341 (World Trade Center)**

**NL-1077 XX Amsterdam(NL)**

(84) **BE**

(72) Erfinder: **Höfgen, Günter, Dr.
Marderweg 8
W-7014 Kornwestheim(DE)**
Erfinder: **Szabo, Laszlo, Dr.
Tubizer Strasse 11
W-7015 Korntal(DE)**

(74) Vertreter: **Gähr, Hans-Dieter, Dipl.-Ing. (FH) et
al
Standard Elektrik Lorenz AG Patent- und
Lizenzwesen Postfach 30 09 29
W-7000 Stuttgart 30(DE)**

(54) Schaltungsanordnung zum gegeneinander entkoppelten Verbinden mehrerer nach dem Frequenzsprung-Verfahren arbeitender Sender an einer Antenne.

(57) Es ist eine Schaltungsanordnung zum entkoppelten Verbinden mehrerer nach dem Frequenzsprung-verfahren arbeitender Sender (TX) mit einer Antenne (A) beschrieben. Jeder Sender arbeitet auf mindestens zwei Frequenzen und ist über Transformationskabel (C) mit einer gleich großen Anzahl von Filtern (f) verbunden, die auf seine Sendefrequenzen fest abgestimmt sind. Jeder Sender arbeitet auf anderen Frequenzen als die übrigen Sender.

## SCHALTUNGSANORDNUNG ZUM GEGENEINANDER ENTKOPPELTEN VERBINDEN MEHRERER NACH DEM FREQUENZSPRUNG-VERFAHREN ARBEITENDER SENDER AN EINE ANTENNE

Die Erfindung bezieht sich auf eine Schaltungsanordnung gemäß Anspruch 1.

Für das entkoppelte Anschalten mehrerer Sender, die auf unterschiedlichen Frequenzen arbeiten und eine gemeinsame Antenne speisen, sind verschiedene Möglichkeiten bekannt. Die einfachste ist ein Verbinden jeweils zweier Senderausgänge mit einer Brückenanordnung (3 dB-Koppler oder Kabelbrücke), von deren Ausgängen einer mit der Antenne und der andere mit einem Abschlußwiderstand verbunden ist. Werden mehrere Sender kaskadenförmig zusammengeschaltet, sind die Verluste von 3 dB pro Senderpaar nicht mehr tragbar.

Aus der DE-PS 30 04 817 sind Schaltungsanordnungen zum gegeneinander entkoppelten Anschalten mehrerer Sender an eine Antenne bekannt, die nicht nach dem Frequenzsprungverfahren arbeiten. Je nach Anzahl der Sender weisen diese Schaltungsanordnungen eine Vielzahl von kaskadenförmig zusammengeschalteten Richtkopplern auf. Zur Vermeidung von Fehlanpassungen oder Energierückflüssen sind zwischen die Richtkoppler Transformationsg lieder und/oder Zirkulatoren geschaltet. Eine derartige Schaltungsanordnung ist sehr aufwendig.

Aus der DE-PS 31 27 566 ist eine Antennenanpaßeinri chtung für einen nach dem Frequenzsprungverfahren arbeitenden VHF-Sender bekannt. Zwischen dem Sender und der Antenne sind mehrere auf verschiedene Frequenzen fest abgestimmte Filter vorhanden, von denen immer nur eines über Schalter mit dem Sender verbunden ist. Technologische Probleme sowie der erforderliche Aufwand stehen einem Einsatz dann entgegen, wenn kurze Schaltzeiten bei hohen Durchgangsleistungen im UHF-Bereich gefordert sind.

Es ist Aufgabe der Erfindung, eine Schaltungsanordnung anzugeben, die mehrere nach dem Frequenzsprungverfahren arbeitende Sender mit einer Antenne verbindet und bei der die obengenannten Probleme oder Nachteile nicht auftreten.

Die Lösung dieser Aufgabe erfolgt mit den im Hauptanspruch genannten Mitteln. Vorteilhafte Ausgestaltungen sind in den Unteransprüchen enthalten.

Die neue Schaltungsanordnung ist insbesondere für den UHF-Bereich geeignet. Sie erlaubt es, eine praktisch beliebige Anzahl von Sendern mit einer Antenne zu verbinden. Auch nachträglich können Erweiterungen um weitere Sender leicht vorgenommen werden.

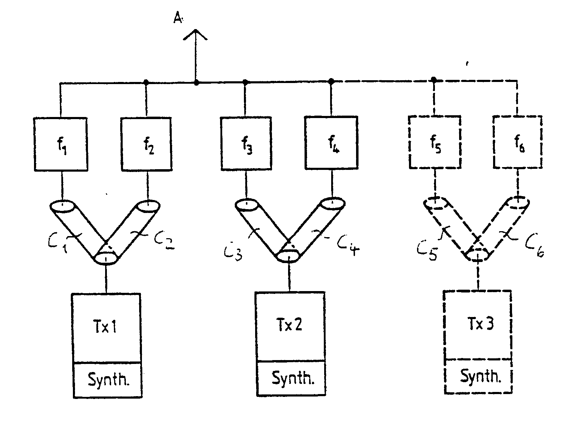

Die Erfindung wird nachstehend anhand eines Ausführungsbeispiels erläutert, das in der einzigen Figur dargestellt ist.

Es weist zwei (drei) Sender Tx1, Tx2, (Tx3) auf, die jeweils einen Synthesizer Synth enthalten. Jeder Sender arbeitet auf zwei Frequenzen im Frequenzsprungbetrieb, wobei jeder Sender andere Frequenzen benutzt als die anderen Sender.

Der erste Sender Tx1 ist über Transformationskabel $C_1$, $C_2$ mit zwei Filtern $f_1$, $f_2$ verbunden, die auf die Frequenzen des ersten Senders fest abgestimmt sind. Die Längen und die Blindwiderstände der Transformationskabel sind so gewählt, daß der Sender je nach gerade benutzter Frequenz nur mit dem auf diese Frequenz abgestimmten Filter hochfrequenzmäßig wirksam verbunden ist.

Der zweite (und dritte) Sender Tx2, (Tx3) sind in gleicher Weise wie der erste Sender Tx1 über Transformationskabel $C_3$, $C_4$, ($C_5$, $C_6$) mit Filtern $f_3$, $f_4$, ($f_5$, $f_6$) verbunden. Die Ausgänge der Filter $f_1$ - $f_4$, ($f_5$, $f_6$) sind mit einer Antenne A verbunden.

In dem dargestellten Ausführungsbeispiel soll davon ausgegangen werden, daß vier (sechs) Signale mit den Frequenzen $f_1$, $f_2$, $f_3$, $f_4$, ($f_5$, $f_6$) als pulsförmige Signale (Bursts) im Rahmen eines TDMA-Schemas nacheinander an die gemeinsame Antenne angeschaltet werden. Die Reihenfolge sei beispielsweise $f_1$ - $f_3$ - ($f_5$) - $f_2$ - $f_4$ - ($f_6$). Die dazu erforderliche Steuerungseinrichtung für die Sender ist in der Figur nicht dargestellt. Somit liefert der Sender Tx1, indem dessen Synthesiser entsprechend gesteuert wird, zuerst die Frequenz $f_1$. Das Ausgangssignal dieses Senders gelangt über das Transformationskabel $C_1$ und über das schmalbandige Topfkreisfilter (Hohlraumresonator) $f_1$ zum gemeinsam Speisepunkt für die Antenne. In diesem Fall sind sowohl das Transformationskabel $C_1$ als auch das Filter $f_1$ angepaßt an den Wellenwiderstand (z.B. 50 Ohm). Im Gegensatz dazu sperrt das Filter $f_2$ die Frequenz $f_1$ und bildet an seinem Eingang einen reinen Blindwiderstand, der über das Transformationskabel $C_2$ als Leerlauf an den Senderausgang Tx1 bzw. den Verzweigungspunkt der Transformationskabel $C_1$, $C_2$ transformiert wird.

Das nächste pulsförmige Signal erzeugt der Sender Tx2 auf der Frequenz $f_3$. Die Funktionen sind dieselben wie oben beschrieben, desgleichen anschließend bei Tx3 (falls implementiert) mit der Frequenz $f_5$.

Das nächste pulsförmige Signal wird wiederum vom Sender Tx1 erzeugt, diesmal allerdings auf der Frequenz $f_2$, so daß der Verbindungsweg jetzt über $C_2$ und das Filter $f_2$ zur Antenne verläuft, und das Filter $f_1$ einen reinen Blindwiderstand an seinem Eingang bildet. Entsprechendes gilt für die Erzeugung und Aussendung der Signale mit den Frequenzen $f_4$ und $f_6$ durch die Sender Tx2 und Tx3.

Bei anderen Ausführungen können mehr als zwei (drei) Sender mit einer Antenne verbunden sein. Auch kann jeder Sender auf mehr als zwei Frequenzen im Frequenzsprungbetrieb senden. Es sind dann entsprechend mehr Filter und Transformationskabel notwendig.

**Ansprüche**

1. Schaltungsanordnung zum entkoppelten Verbinden von m Sendern (Tx) mit einer gemeinsamen Antenne (A), wobei die Sender nach dem Frequenzsprungverfahren auf n verschiedenen Frequenzen arbeiten und jeder Sender auf zwei oder mehreren anderen Frequenzen arbeitet als die anderen Sender,
mit n auf jeweils eine der n Frequenzen fest abgestimmten Filtern (f),
wobei jeder Sender über die Filter mit der Antenne verbunden ist, die auf die von dem betreffenden Sender benutzten Frequenzen abgestimmt sind, und die Verbindung zwischen den Sendern und den Filtern durch Transformationskabel (C) erfolgt.
2. Schaltungsanordnung nach Anspruch 1, dadurch gekennzeichnet, daß n = 2m ist.
3. Schaltungsanordnung nach Anspruch 1 oder 2, dadurch gekennzeichnet, daß die Längen und die Blindwiderstände der Transformationskabel (C) so gewählt sind, daß bei jeder Frequenz der Sender immer nur mit dem auf diese Frequenz abgestimmten Filter hochfrequenzmäßig wirksam verbunden ist.
4. Schaltungsanordnung nach einem der vorhergehenden Ansprüche, dadurch gekennzeichnet, daß die Filter (f) Hohlraumresonatoren sind.
5. Schaltungsanordnung nach einem der vorhergehenden Ansprüche, dadurch gekennzeichnet, daß die Sender pulsförmige Signale (Bursts) erzeugen.
6. Schaltungsanordnung nach Anspruch 5, dadurch gekennzeichnet, daß die Sender die pulsförmigen Signale im Rahmen eines TDMA-Schemas aussenden.